# EUROPEAN PATENT APPLICATION

(11) **EP 3 182 459 A1**
(43) Date of publication of application: **21.06.2017**
(21) Application number: 16176421.2
(22) Date of filing: 27.06.2016
(51) Int. Cl.: H01L 29/06, H01L 29/786, H01L 29/78, H01L 29/66

(54) **METHOD OF PRODUCING A PRE-PATTERNED STRUCTURE FOR GROWING VERTICAL NANOSTRUCTURES**

(30) Priority: 15.12.2015 EP 15200135
(71) Applicant: IMEC VZW, 3001 Leuven (BE)
(72) Inventor: Chan, Boon Teik, 3001 Leuven (BE); Merckling, Clement, 3001 Leuven (BE); Devriendt, Katia, 3001 Leuven (BE); Rooyackers, Rita, 3001 Leuven (BE)
(74) Representative: Patent Department IMEC

(57) **Abstract**

A method for producing a pre-patterned structure comprising at least one cavity for growing a vertical nanostructure, the method comprising providing at least one structure protruding and extending upwardly from a main surface of a substrate. The at least one protruding structure has a main portion having a height H and an upper portion on the main portion. At least the main portion comprises a monocrystalline semiconductor material. The at least one protruding structure is embedded in a dielectric material. At least an excess portion of the dielectric material is removed by performing a surface flattening process. Thereafter, at least one cavity is formed having a depth of d by removing the upper portion.

## Description

### Technical field of the invention

The present invention is related to the field of semiconductor devices. More specifically, it relates to the production of a pre-patterned structure for growing vertical nanostructures. The main application of the pre-patterned structure is in the fabrication of vertical devices such as vertical field effect transistor, vertical junction-less field effect transistor, vertical tunnel field effect transistor, vertical junction-less tunnel field effect transistor and complementary hetero-junction vertical tunnel field effect transistor.

### Background of the invention

As the size of the field effect transistors keep on getting reduced, new material choices are being explored and implemented as well as new device design concepts in an effort to provide better device performance and to increase the device density.

Group III-V compound semiconductor materials, in this respect, have gained a lot of interest due to the fact that they have intrinsically a higher carrier mobility in comparison to silicon. In addition to fabricating a fin-type field effect transistor (FinFET), vertical device architectures that are based on the growth of vertical nanostructures such as vertical nanowires or vertical nanosheets have become attractive. Examples of such vertical device architectures include vertical field effect transistor, vertical tunnel field effect transistor (TFET), vertical junction-less field effect transistor, vertical junction-less tunnel field effect transistor and complementary hetero-junction vertical tunnel field effect transistor comprising Group III-V compound semiconductor materials.

Of such nanostructures, in order to facilitate the growth of vertical Group III/V compound semiconductor nanowires on desired locations or regions of a chip without the need for using metal catalysts, a dielectric mask pattern or a dielectric template comprising openings is used. Group III/V compound semiconductor vertical nanowires are then grown by an epitaxial growth process in such openings. The openings in such dielectric mask pattern or dielectric template is made by performing a lithographic patterning process followed by an etch process.

Noborisaka et. al. ("Catalyst-free growth of GaAs nanowires by selective-area metalorganic vapor-phase epitaxy", Applied Physics Letters, v. 86, pp. 213102, 2005*)* discloses a method to grow catalyst-free GaAs nanowires by forming a SiO₂ mask pattern comprising openings on a GaAs (111)B substrate. They disclose using electron-beam lithography and wet-chemical etching techniques for defining the openings in the SiO₂ layer. Although electron-beam provides patterning of the openings as desired, it has the disadvantage of having low throughput in mass production. On the other hand, the shrinkage in the size of the transistors leads to the fact that the size of the openings, in which Group III/V compound semiconductor material vertical nanowires are grown, have to be reduced. Thus, wet-chemical etching techniques may be challenging in terms of being able to remove the complete dielectric to create full openings accessing the substrate. Dry etch process can remedy this, however, using a dry etch process to create the openings results in damages on the substrate exposed at the bottom area of these openings. Such a damaged substrate surface is disadvantageous for the defect free growth of Group III/V compound semiconductor material vertical nanowires.

Therefore, there is a need in the art for good methods allowing the growth of vertical Group III/V compound semiconductor material nanostructures, such as nanowires or nano-sheets on an undamaged substrate, so that vertical devices such as vertical field effect transistor, vertical junction-less field effect transistor, vertical tunnel field effect transistor (TFET), vertical junction-less tunnel field effect transistor and complementary hetero-junction vertical tunnel field effect transistor can be produced.

### Summary of the Invention

It is an object of the present invention to provide good methods for producing a pre-patterned structure for growing vertical nanostructures.

It is an advantage of embodiments of the present invention that the method provides a simple and cost efficient integration scheme for growing vertical nanostructures.

It is an advantage of embodiments of the present invention that the method enables producing a pre-patterned structure for growing vertical Group III/V compound binary, ternary or quaternary semiconductor nanostructures; for instance nanowires, nano-sheets or fin structures.

It is an advantage of embodiments of the present invention that the method enables producing a pre-patterned structure for growing vertical Group III/V compound binary, ternary or quaternary semiconductor nanostructures starting from a surface having an undamaged crystal lattice.

It is an advantage of embodiments of the present invention that the method allows for producing a pre-patterned structure for growing vertical Group III/V compound binary, ternary or quaternary semiconductor nanostructures (only) on the desired locations on a wafer.

It is an advantage of embodiments of the present invention that the method allows for producing a pre-patterned structure for growing vertical Group III/V compound binary, ternary or quaternary semiconductor nanostructures suitable for technology nodes N10 or smaller in the semiconductor industry.

It is an advantage of embodiments of the present invention that the method allows for producing a pre-patterned structure for growing vertical Group III/V compound binary, ternary or quaternary semiconductor fin structures having a self-aligned bottom isolation.

It is an advantage of embodiments of the present invention that the method further allows for fabricating a vertical field effect transistor comprising the pre-patterned structure produced according to embodiments of the present invention.

The above objective is accomplished by a method according to the present invention.

In a first aspect, the present invention relates to a method of producing a pre-patterned structure comprising at least one cavity for growing a vertical nanostructure. The method comprises providing at least one structure protruding and extending upwardly from a main surface of a substrate. The at least one protruding structure has a main portion and an upper portion on the main portion. The main portion has a height H and at least the main portion comprises a monocrystalline semiconductor material. The at least one protruding structure is embedded in a dielectric material. At least an excess portion of the dielectric material is removed by performing a surface flattening step, thereby exposing a top surface of the upper portion and thereby forming a flattened surface of the top surface and the dielectric material. Thereafter, at least one cavity is formed by removing the upper portion. The at least one cavity has a depth of d and exposes a top surface of the main portion of the at least one protruding structure.

In embodiments, the pre-patterned structure may be a pre-patterned semiconductor structure.

In embodiments, the vertical nanostructure may be a vertical nanosheet, vertical nanowire or a fin structure. The vertical nanostructure maybe a vertical semiconductor nanostructure.

In embodiments, the depth D may be smaller than the height H.

It is an advantage of the embodiments of the present invention that the depth D is smaller than the height H allowing for growing vertical Group III/V compound semiconductor nanostructures with restricted defects.

In embodiments, removing the upper portion of the at least one protruding structure may be done by etching the upper portion selective to the dielectric material. This is advantageous since it allows for removing the upper portion without decreasing the thickness of the dielectric material.

In embodiments, the at least main portion and the substrate may be made of the same monocrystalline semiconductor material. This is advantageous due to the fact that the vertical nanostructure may directly be grown on a top surface of the at least monocrystalline main portion so that additional process steps required to remove the at least main portion to expose the monocrystalline substrate for growing the vertical nanostructure may be avoided.

In embodiments, the material of the upper portion may be different than the material of the main portion. This is advantageous due to the fact that this opens room for using varying combinations of different materials that may be used to form the upper portion and that may be used as the dielectric material.

In embodiments, the method may further comprise performing an ion implantation process before embedding the at least one protruding structure in the dielectric material. This allows for doping a lower part of the main portion and a region of the substrate underneath the at least one protruding structure with an n-type or a p-type dopant.

It is advantageous to dope the substrate underneath the at least one protruding structure since this helps to lower the contact resistance towards the lower part of the nanostructure.

It is also an advantage to perform the ion implantation process before embedding the at least one protruding structure in the dielectric material due to the fact that degradation or damage to a top surface of the main portion of the at least one protruding structure may be avoided.

In embodiments, providing the at least one structure may comprise obtaining a substrate. The substrate may be covered with a patterning layer on a side thereof. A lithographic patterning step may be performed on the patterning layer, thereby forming at least one patterning layer feature on that side of the substrate. Using the at least one patterning layer feature as a mask, anisotropic etching into the substrate may be performed, thereby forming the at least one structure protruding from the main surface.

In embodiments, the anisotropic etching is performed by an anisotropic dry etch process. The anisotropic dry etch process is advantageous since it allows for continuous scaling in semiconductor industry.

In embodiments, the patterning layer may be a patterning layer stack. The patterning layer stack may comprise an organic layer overlying and in contact with the substrate and a patterning dielectric material overlying and in contact with the organic layer. It is advantageous to have this patterning layer stack comprising the organic layer and the patterning dielectric material since it provides good etch selectivity, thereby resulting in anisotropic etching to form the at least one protruding structure.

In embodiments, the monocrystalline semiconductor material may be a (111) oriented Group IV semiconductor material or a (111)B oriented Group III/V compound semiconductor material.

In embodiments, the (111) oriented Group IV semiconductor material may be a (111) oriented silicon or a (111) oriented germanium. It is advantageous to have the (111) oriented Group IV semiconductor material or a (111)B oriented Group III/V compound semiconductor material since they facilitate the growth of vertical nanostructures. Growing vertical nanostructures are advantageous since they allow for further scaling of feature sizes and increasing device density in semiconductor industry.

In embodiments, the present invention relates to a method for fabricating a vertical field effect transistor. The method comprises producing the pre-patterned structure according to any embodiments of the present invention. A vertical nanostructure is epitaxially grown in the at least one cavity. The vertical nanostructure comprises a channel region positioned in between a source region and a drain region. A gate stack is provided to the vertical nanostructure. The gate stack is suitable for controlling the channel region.

In embodiments, the vertical nanostructure may comprise a Group IV or a Group III/V compound semiconductor material.

In embodiments, the at least one cavity may be a hole and the vertical nanostructure may be a nanowire that is epitaxially grown in the hole.

In embodiments, the at least one cavity may be a trench and the vertical nanostructure may be a nanosheet or a fin structure that is epitaxially grown in the trench.

In a second aspect, the present invention relates to a pre-patterned structure comprising at least one cavity for growing a vertical nanostructure. The pre-patterned structure comprises a substrate and at least one structure protruding and extending upwardly from a main surface of the substrate. The at least one protruding structure has a top surface and a height of h and comprises a monocrystalline semiconductor material. A dielectric material overlays and is in contact with the main surface. The dielectric material comprises at least one cavity having a depth of d. The at least one cavity exposes, at its bottom, the top surface of the at least one protruding structure and it is aligned with this at least one protruding structure.

In embodiments, the at least one structure protruding and extending upwardly from the main surface of the substrate may consist of a main portion. The main portion has the height H.

In embodiments, the at least one cavity may be a hole allowing for growth of a vertical nanowire.

In embodiments, the at least one cavity may be a trench allowing for growth of a vertical nanosheet or a fin structure.

In embodiments, the depth D may be smaller than the height H.

This is advantageous since it allows for the growth of vertical Group III/V compound semiconductor material nanostructures with restricted defects.

In embodiments, the at least one protruding structure and the substrate may comprise same monocrystalline semiconductor material.

In embodiments, a lower part of the main portion and a region underneath the at least one protruding structure may be doped with a n-type or a p-type dopant element.

In embodiments, the present invention relates to a vertical field effect transistor. The vertical field effect transistor comprises the pre-patterned structure according to any embodiments of the present invention. A vertical nanostructure is present in the at least one cavity. The vertical nanostructure comprises a channel region positioned in between a source region and a drain region. A gate stack is present suitable for controlling the channel region. The monocrystalline semiconductor material is a (111) oriented Group IV semiconductor material or a (111)B oriented Group III/V compound semiconductor material.

In embodiments, the vertical nanostructure may comprise a Group III/V compound semiconductor material or a Group IV semiconductor material..

In embodiments, the vertical nanostructure may be vertical nanowire, vertical nanosheet or a fin structure.

### Brief description of the figures

**Fig. 1** shows flowchart of producing a pre-patterned structure according to embodiments of the present invention.
**Fig. 2** shows flowchart of providing at least one protruding structure according to embodiments of the present invention.
**Fig. 3a** **-** **Fig. 3g** **show a** schematic representation of the method according to embodiments of the present invention.
**Fig. 4a** **-** **Fig. 4g** **show a** schematic representation of the method according to embodiments of the present invention.
**Fig. 5** shows schematically a tilted view of a pre-patterned structure produced according to embodiments of the present invention, where the at least one cavity is a hole.
**Fig. 6** shows schematically a tilted view of a pre-patterned structure produced according to embodiments of the present invention, where the at least one cavity is a trench.

### Detailed description of the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

It is to be noticed that the term *"comprising",* used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof.

Reference throughout the specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout the specification are not necessarily all referring to the same embodiment, but may. Furthermore, the particular features, structures or characteristics may be combined in any suitable manner, as would be apparent to one of ordinary skill in the art from the disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. The method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into the detailed description, with each claim standing on its own as a separate embodiment of the invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of the description.

The following terms are provided solely to aid in the understanding of the invention.

As used herein and unless provided otherwise, the term ***"technology node"*** refers to devices in semiconductor processing having a gate length or fin width at the indicated number.

As used herein and unless provided otherwise, the term ***"exposed"*** refers to a layer, a surface or a region that is in contact with surrounding atmosphere.

As used herein and unless provided otherwise, the term ***"self-aligned bottom isolation"*** refers to the fact that the cavity in the dielectric has a certain depth D which determines the gate underlap to the drain if a gate stack is provided subsequent to the growth of the nanostructure. For instance, in case of a TFET device, this will suppress the turn on of the ambipolar device.

As used herein and unless provided otherwise, the term ***"etching a material selective to another material"*** refers to etching the material without or with minimum etching of the another material.

As used herein and unless provided otherwise, the term ***"aspect ratio"*** refers to the ratio of a height to a width of a structure or a cavity.

As used herein and unless provided otherwise, the term ***"etch back uniformity"*** refers to the uniformity within wafer, which can be of about 5% of the total material removal. Preferably, this is of about 2%.

As used herein and unless provided otherwise, the term ***"the at least one cavity being aligned with the at least one protruding structure"*** refers to the at least one cavity and the at least one protruding structure having the same surface area or the same projection.

As used herein and unless provided otherwise, the term "distinguishable" refers to layers or portions comprising a different material.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

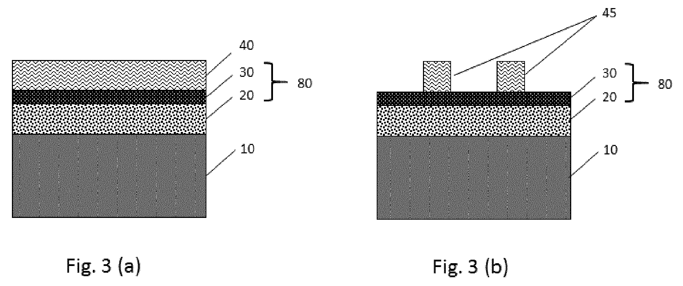

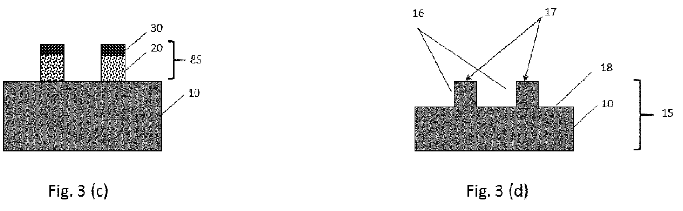

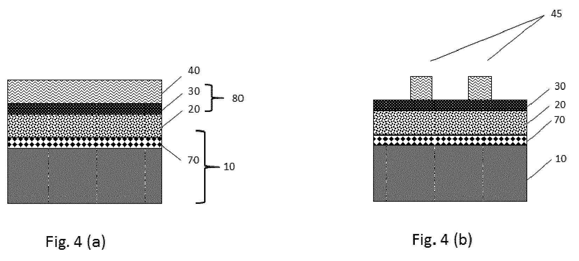

The method (800) according to the first aspect is illustratedschematically in **Fig. 3a to Fig. 3g** and **Fig. 4a to Fig. 4g**. The figures show corresponding cross-sections of the structure (15) at different stages of the method (800). Purely to facilitate understanding, different layers are shown with different filling patterns, however; this should not be construed in any limiting sense.

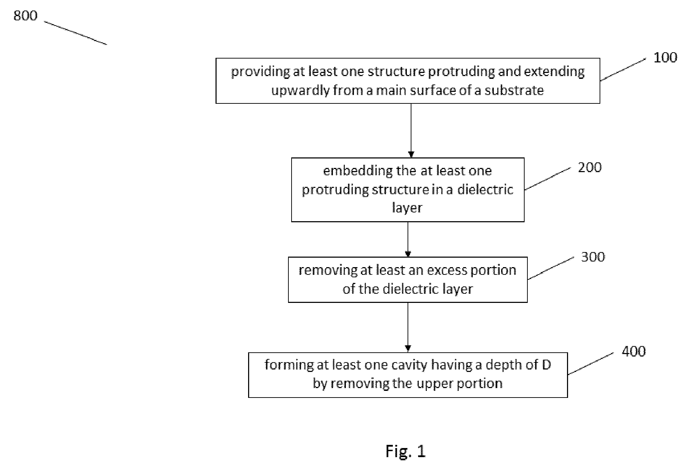

We now refer to **Figure 1, Figure 3d to Figure 3g** and **Figure 4d to Figure 4g**.

**Figure 1** shows a flowchart of producing a pre-patterned structure according to embodiments of the present invention.

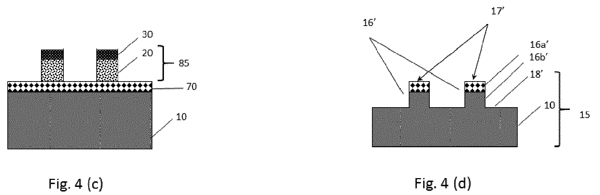

The method (800) starts with providing (100) at least one structure protruding and extending upwardly (16, 16') from a main surface (18, 18') of a substrate (10) as schematically shown in Fig. 3d and Fig. 4d.

In embodiments, the substrate (10) may be a (111) oriented bulk monocrystalline Group IV semiconductor substrate or a (111)B oriented Group III/V binary compound semiconductor substrate or may even be a (111)B ternary or quaternary pseudo-substrate.

In embodiments, the bulk (111) oriented monocrystalline Group IV semiconductor substrate may be a bulk (111) oriented silicon or a bulk (111) oriented germanium substrate.

In embodiments, the bulk (111)B oriented monocrystalline Group III/V compound semiconductor substrate may be a (111)B oriented binary Group III/V semiconductor material such as for example, gallium arsenide (GaAs), indium phosphide (InP), indium arsenide (InAs), gallium phosphide (GaP), gallium antimonide (GaSb) or indium indium antimonide (InSb).

In alternative embodiments, the substrate (10) may include for example an insulating layer such as a SiO₂ or a Si₃N₄ layer in addition to a semiconductor substrate portion. Thus, the term substrate may also include a silicon-on-insulator (SOI) or a germanium-on-insulator (GeOI) substrate with a buried oxide layer and a layer of (111) oriented silicon or (111) oriented germanium monocrystalline semiconductor material on top thereof.

In embodiments, the at least one protruding structure (16, 16') has a main portion and an upper portion. At least the main portion comprises a monocrystalline semiconductor material.

In embodiments, the at least one protruding structure (16, 16') may be a cylinder-shaped or a hexagon shaped pillar having a predetermined diameter and a predetermined height or it may be a nanosheet or a fin structure having a predetermined width and a predetermined length.

In preferred embodiments, the upper portion and the main portion have the same width or the same diameter.

In embodiments, at least the main portion of the protruding structure (16, 16') consists of a monocrystalline semiconductor material.

In embodiments, the monocrystalline semiconductor material of the at least main portion may be a (111) oriented Group IV semiconductor material or a (111)B oriented Group III/V compound binary semiconductor material.

In preferred embodiments, the monocrystalline semiconductor material of the at least main portion may be a (111) oriented Si or a (111) oriented Ge.

In embodiments, the main portion and the upper portion may be manufactured of the same material. Thus, in these embodiments, both the upper portion and the main portion may be manufactured from the same monocrystalline semiconductor material. In these embodiments, the upper portion and the main portion are indistinguishable as illustrated in Fig 3d.

In embodiments, the upper portion and the main portion may be manufactured of different materials as schematically illustrated in Fig. 4d. In these embodiments, the upper portion (16a') and the main portion (16b') are distinguishable. In these embodiments, the upper portion may consist of silicon nitride (such as for example Si₃N₄) or silicon oxide (such as for example SiO₂).

In preferred embodiments, the height of the upper portion may be less than half the height of the main portion.

In embodiments, the at least main portion of the protruding structure and the substrate (10) may be manufactured of the same monocrystalline semiconductor material.

The at least one protruding structure (16, 16') may be embedded (200) in the dielectric material (50).

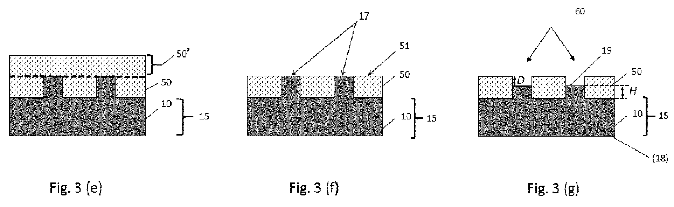

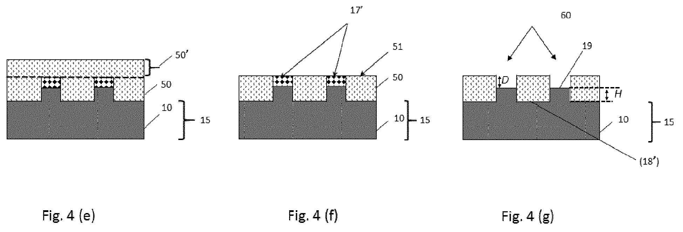

In embodiments, the dielectric material (50) may embed the lateral walls of the at least one protruding structure (16, 16') and may also embed a top surface (17, 17') of the upper portion of the at least one protruding structure (16, 16'), thereby forming an excess portion (50') over the top surface (17, 17') **(****Fig. 3e** **and** **Fig. 4e****).** A surface flattening process may be performed in order to remove at least this excess portion (50') of the dielectric material. **(****Fig. 3f** **and** **Fig. 4f****).** Removal of the at least excess portion (50') leaves the top surface of the upper portion exposed and forms a flattened surface (51). This flattened surface (51) comprises the top surface and the dielectric material (50) **(****Fig. 3f** **and** **Fig. 4f****).**

The surface flattening process may stop such that the exposed top surface of the upper portion after the surface flattening process corresponds to the top surface (17, 17') of the upper portion before embedding in the dielectric material (50) **(****Fig. 4d****).**

Alternatively, the surface flattening process may continue such that a part of the upper portion of the at least one protruding structure (16, 16') is further removed together with the dielectric material (50). As a result, the exposed top surface of the upper portion does not correspond to the top surface (17, 17') of the upper portion before embedding in the dielectric material (50).

It is advantageous to remove a part of the upper portion together with the dielectric material (50) during the surface flattening process since it allows for reducing the height of the at least one protruding structure (16, 16').

This may be particularly advantageous when, for instance, the upper portion and the main portion are distinguishable (Fig. 4d) and when the upper portion has a height (or thickness) higher than a height (or thickness) of the main portion. As a result of the surface flattening process, the height of the upper portion may be reduced down to a height such that it will be removed easily and without resulting in etch back non-uniformity. This reduced height is at least 10 nm. Preferably, this reduced height in the range of 5 nm to 10 nm.

In embodiments, the dielectric material (50) may be provided such that only the lateral walls of the at least one protruding structure are embedded, while the top surface (17, 17') of the upper portion of the at least one protruding structure (16, 16') is exposed and abuts on a same surface as the dielectric material (50) thus making the surface flattening process become obsolete.

One example, for instance, the surface flattening process becomes obsolete is when the upper portion (16a') and the main portion (16b') of the at least one protruding structure (16') are distinguishable, such as that schematically shown in **Fig. 4d** **and** **Fig. 4e****.** The surface flattening process becomes obsolete provided that the height (or thickness) of the upper portion is at most 10 nm. Preferably, the height (or thickness) of the upper portion is in the range of 5 nm to 10 nm.

In embodiments, this surface flattening process may be a chemical mechanical planarization process (CMP).

In embodiments, the dielectric material (50) may be oxide, preferably silicon oxide, or nitride, preferably silicon nitride. The silicon oxide may be High Density Plasma oxide (HDP) or a Plasma Enhanced Chemical Vapour Deposited oxide. In order to improve the quality of the silicon oxide, a thermal annealing process may be performed thus, densifying the silicon oxide. The thermal treatment process may, for example, be performed using H₂O at 750 °C with a duration of 30 minutes followed by exposure to N₂ atmosphere at 1050 °C with a duration of 30 minutes. When a HDP oxide is used, the thermal annealing may become obsolete. The silicon nitride may be deposited by performing a Plasma Enhanced Chemical Vapour Deposition (PE-CVD) process or a Low Pressure Chemical Vapour Deposition (LP-CVD) process.

In embodiments where the material of the upper portion is different than the material of the main portion, the dielectric material (50) may for example comprise silicon nitride and the upper portion may comprise silicon oxide or vice versa

Following the removal (300) of at least the excess portion of the dielectric material (51) **(****Fig. 3f** **and** **Fig. 4f****),** at least one cavity (60) may be formed (400) by removing completely the upper portion **(****Fig. 3g** **and** **Fig. 4g****).** The at least one cavity (60) may have a depth D extending down from the flattened surface (51). The depth D may correspond to the height (thickness) of the upper portion of the at least one protruding structure (16, 16') that is removed after performing the surface flattening process as schematically shown in **Fig. 3f** and **Fig 4f****.** Removal of the upper portion may result in at least one structure protruding and extending upwardly from a main surface (18, 18') of the substrate (10). The at least one structure protruding and extending upwardly from the main surface is the main portion of the at least one protruding structure (16, 16') that has the height H.

The at least one cavity (60) exposes, at its bottom, a top surface (19) of the main portion of the at least one protruding structure (16, 16'). The depth D may be smaller than the height H of the at least one protruding structure (16, 16'). The bottom of the at least one cavity (60) may not extend down to or lower than the level of the main surface (18, 18') of the substrate (10).

In embodiments, the depth D of the at least one cavity (60) may be at most 10 nm, preferably between 5nm and 10nm.depth DA depth D being higher than 10 nm may result in a high density of defect formation of vertical Group III/V compound semiconductor nanostructure grown in the at least one cavity (60). The defects may include misfit or threading dislocations that may originate due to lattice mismatch between the vertical Group III/V compound semiconductor nanostructure and the main portion of the at least one protruding structure. The defects may also include point defects, such as for example interstitials, vacancies or anti-sites, due to the presence of impurities such as for example, dopant elements. The high density of defect formation during the growth of a vertical nanostructure in a cavity having a depth higher than 10 nm may have risk of having the defects in a channel region of the vertical nanostructure. This may lead to device performance-related issues when a vertical field effect transistor is fabricated using such a vertical nanostructure.

In embodiments, the at least one cavity (60) may be a hole or a trench. The hole or the trench, may be arranged in an array whereby each hole or each trench may be separated from each other vertically and/or horizontally by a predetermined distance.

In embodiments, a nanowire may be grown in the hole. This nanowire may be a single nanowire.

In embodiments, a nanosheet or a fin structure may be grown in the trench.

It is advantageous to remove the upper portion of the at least one protruding structure since this upper portion may comprise defects inherent to the CMP process such as for instance, due to erosion or due to a preferential attack by one or more of the CMP slurry constituents. Removal of this part allows to obtain a surface free of defects originating from the CMP process.

It is known by persons skilled in the art that the CMP process may cause a dishing problem on wide areas on a wafer, where, typically, no structures are present. Dishing results in reducing the thickness of the dielectric material in the wide areas in reference to that in the areas, where structures are present.

It is an advantage of the method of the present invention that the pre-patterned structure is ready for growing the vertical nanostructure after the removal of the upper portion without requiring a further recessing of the dielectric material (50).

Further recessing of the dielectric material (50) may be necessary when the at least one structure protruding and extending upwardly (16, 16') from the main surface (18, 18') of the substrate (10) has to be, completely, removed to create the cavity for vertical nanostructure growth. In this case, following the CMP process, the dielectric material may, thus, be further recessed, which is subsequently followed by removing the at least one protruding structure to, thereby, form the cavity to grow the vertical nanostructure.

This further recessing of the dielectric material may pose the risk of removing, from the wide areas, the remaining dielectric material, which is the reduced part of the dielectric material due to dishing occurring in these wide areas as a result of the CMP process. This may lead to undesirable formation of vertical structures on these wide areas that may become open, thus exposing the underlying substrate. This further recessing may, additionally, pose the risk of topography changes over the surface of the wafer, which is also undesirable.

The height of the at least one protruding structure (16, 16') may be adjusted by taking into consideration how much dishing would be allowed in the wide field after performing the surface flattening step such that the main surface (18, 18') of the substrate (10) would still be covered by the dielectric material (50) in the wide field in the presence of dishing.

In embodiments, removal of the upper portion may be done by etching the upper portion selective to the dielectric material (50). This is advantageous so that the thickness of the dielectric layer obtained after performing the surface flattening step may be preserved. The dielectric layer obtained after performing the surface flattening step may be used as a shallow trench isolation for the fabrication of vertical field effect transistor, where a vertical nanostructure may be grown in the at least one cavity (60).

In preferred embodiments, the selective removal may be done by performing a wet etch process. This allows for removing the upper portion so that the top surface (19) is not damaged, such as for instance the lattice is not damaged.

In embodiments, where the upper portion of the at least one protruding structure is silicon oxide and the dielectric material is silicon nitride, removal of the upper portion may be done by using an aqueous hydrogen fluoride, which removes silicon oxide selective to silicon nitride. Alternatively in these embodiments, the upper portion may be removed by performing a vapour treatment of aqueous hydrogen fluoride solution.

In embodiments, where the upper portion of the at least one protruding structure is silicon nitride and the dielectric material is silicon oxide, removal of the upper portion may be done by using an aqueous phosphoric acid solution.

It is further advantageous to have the depth D of the at least one cavity (60) at most 10 nm or preferably, in the range of 5 nm to 10 nm for reasons of etch back uniformity. Since the selective removal may, preferably, be done by the wet etch process, aspect ratio (AR) of the at least one cavity (60) has an influence on the etch back uniformity. Cavities having an AR value of higher than 3 may be difficult to form by means of the wet etch process.

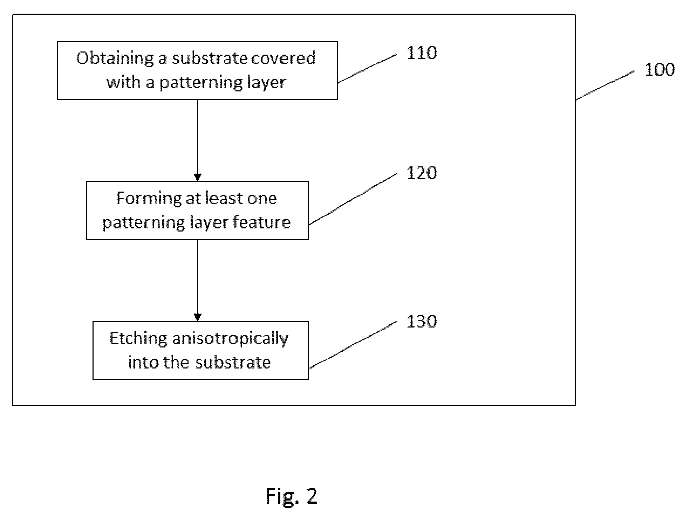

We now refer to **Figure 2**, **Figure 3a to Figure 3d and Figure 4a to Figure 4d**.

**Figure 2** shows a flowchart of providing the at least one protruding structure according to an embodiment of the present invention.

**Fig.3a to Fig 3c** and Fig. **4a to Fig. 4c** illustrates a possible manner of providing the at least one protruding structure (16, 16'). The figures show corresponding cross-sections at different stages of providing (100) the at least one protruding structure (16, 16').

A substrate (10) is obtained (110) covered, on a side, with a patterning layer.

In embodiments, the patterning layer may be a photoresist layer. This photoresist layer may be in direct contact with the substrate (10). Forming (120) at least one patterning layer feature may comprise performing a lithographic patterning process thereby forming at least one patterned photoresist feature (45). The at least one patterned photoresist feature (45) may correspond to the at least one patterning layer feature. Using the at least one patterned photoresist feature (45) as a mask, an anisotropic etching into the substrate may be performed (130), thereby forming the at least one protruding structure (16, 16').

In preferred embodiments, the patterning layer may be a patterning layer stack (80). The patterning layer stack (80) may comprise an organic layer (20) and a second dielectric material (30) overlying and in contact with the organic layer (20). A photoresist layer (40) may be provided on the second dielectric material (30).

In these preferred embodiments, forming (120) at least one patterning layer feature (85) may comprise performing a lithographic patterning process, thereby forming at least one patterned photoresist feature (45). Using the at least one patterned photoresist feature (45) as a mask, the patterning layer stack (80) may be etched, thereby forming the at least one patterning layer feature (85).

The etching of the patterning layer stack (80) may comprise etching the second dielectric material (30) and thereafter etching the organic layer (20).

The etching of the second dielectric material (30) may be done by using a plasma produced from an etching gas comprising a carbon-comprising reactant and a halogen-containing reactant.

In embodiments, the carbon-containing reactant may be a hydrofluorocarbon, such as CH₂F₂. The halogen-containing reactant may be SF₆.

The etching gas may further comprise nitrogen gas (N₂) and it may be provided into the process chamber by the use of a noble carrier gas such as helium (He).

The etching of the organic layer (20) may be done by using a plasma produced from an etching gas comprising an oxygen reactant such as O₂.

The etching gas may be provided into the process chamber by the use of a noble carrier gas such as argon (Ar).

During the etching of the patterning layer stack (80) in order to form the at least one patterning layer feature (85), the at least one patterned photoresist feature (45) may be consumed during the etching of the organic layer (20) due to the fact that the patterned photoresist feature (45) is an organic material.

Using the at least one patterning layer feature (85) as a mask, an anisotropic etching into the substrate (10) may be performed (130), thereby forming the at least one protruding structure (16, 16').

The anisotropic etching, in embodiments of the present invention may be an anisotropic dry etching or an anisotropic wet etching.

In preferred embodiments, it is advantageous that the anisotropic etching is the anisotropic dry etching since it aids in the continuous scaling in the semiconductor industry.

In embodiments, a plasma produced from an etching gas comprising a carbon-comprising reactant and a halogen-containing reactant may be used to etch into the substrate (10) by performing the anisotropic dry etching.

In embodiments, the carbon-comprising reactant may be selected from a group consisting of a hydrocarbon, a fluorocarbon and a hydrofluorocarbon.

The hydrocarbon may be CH₄, C₂H₄, C₃H₈, or C₂H₂.

The fluorocarbon may be C₄F₈, C₄F₆, CF₄, C₂F₆, C₅F₈, C₃F₆, or C₆F₆.

The hydrofluorocarbon may be CH₃F, CHF₃, C₂HF₅, or CH₂F₂.

In preferred embodiments, the carbon-comprising reactant may be a hydrofluorocarbon.

Yet in preferred embodiments, the hydrofluorocarbon may be CH₂F₂.

In embodiments, the halogen-containing-containing reactant may be selected from a group consisting of SF₆, NF₃ and CF₄.

In preferred embodiments, the halogen-containing reactant may be SF₆.

In embodiments, where the capping layer (70) may be present as the upper layer of the substrate (10) **(****Fig. 4a****),** the capping layer (70) may be etched using the plasma during the anisotropic dry etching into the substrate (10), whereby the at least one patterning layer feature (85) is used as mask.

In embodiments, the capping layer (70) may be a dielectric material such as an oxide (SiO₂) or a nitride (Si₃N₄).

In embodiments, the capping layer may be provided by Plasma Enhanced Chemical Vapour Deposition (PE-CVD) or Low Pressure Chemical Vapour Deposition (LP-CVD).

In embodiments, the patterning dielectric material (30) of the at least one patterning layer feature (85) **(****Fig. 4c****)** may be etched during the etching of the capping layer (70). Thereafter, dry anisotropic etching may continue into the substrate (10) using the organic layer (20) of the at least one patterning layer feature (85) as a mask.

In embodiments where a silicon oxide may be used as the capping layer (70), etching of the capping layer (70) may be done by using a plasma produced from an etching gas comprising a carbon-comprising reactant. The carbon-comprising reactant may be selected from a group consisting of a fluorocarbon and a hydrofluorocarbon.

The fluorocarbon may be CF₄.

The hydrofluorocarbon may be CH₂F₂.

The etching gas may be provided into the process chamber by the use of a noble carrier gas. In embodiments, this noble carrier gas may be helium (He).

In embodiments where a silicon nitride may be used as the capping layer (70), etching of the capping layer (70) may be done by using a plasma produced from an etching gas comprising a carbon-comprising reactant and an oxygen reactant. The carbon-comprising reactant may be a hydrofluorocarbon.

The hydrofluorocarbon may be CHF₃.

The oxygen reactant may be O₂.

The etching gas may be provided into the process chamber by the use of a noble carrier gas. In embodiments, this noble carrier gas may be argon (Ar).

In embodiments, performing a lithographic patterning process may comprise exposing the photoresist layer (40), through a mask and developing the exposed photoresist layer to form the patterned photoresist feature (45). The patterned photoresist feature may have a shape of a dot or a shape of a fin structure. The lithographic patterning process may be carried out by performing, such as for example, a ultra violet(UV), a deep ultraviolet (DUV), an electron beam (e-beam) or an extreme ultra violet (EUV) lithography process.

In alternative embodiments, the patterning layer may be a directed self-assembly (DSA) template stack. After performing a directed self-assembly (DSA) patterning process, as known to persons skilled in the art, the at least one patterning layer feature (85) may be formed. The at least one patterning layer feature (85) formed, in these embodiments, may have a shape of a pillar, a shape of a cylinder, a shape of a fin structure or a shape of a nanosheet.

In embodiments, the organic layer (20) may be overlying and in contact with the substrate (10) as schematically shown in **Fig. 3a****.** The at least one protruding structure (16) formed after etching anisotropically into the substrate (10) may extend upwardly from a main surface (18) of the substrate (10) as schematically shown in **Fig. 3d****.** The upper portion and the main portion of the at least one protruding structure (16) are indistinguishable.

In alternative embodiments, the organic layer (20) may be overlying and in contact with an upper layer (70) of the substrate (10) as schematically shown in **Fig. 4a****.** The upper layer (70) of the substrate (10) may be a capping layer. It is an advantage of these embodiments of the present invention that the capping layer (70) protects a top surface of the main portion of the at least one protruding structure (16') from damage that could be caused by the surface flattening process. Damage caused by the surface flattening process may lead to the formation of defects in the grown vertical nanostructure. In these alternative embodiments, the at least one protruding structure (16') formed after etching anisotropically into the substrate (10) may extend upwardly from a main surface (18') of the substrate (10) as schematically shown in **Fig. 4d****.** The upper portion (16a') and the main portion (16b') of the at least one protruding structure (16') are distinguishable.

The width or the diameter of the at least one protruding structure (16, 16') may be determined by the width or the diameter of the at least one patterning layer feature (85).

In embodiments, a trimming process may be performed to have reduced width or reduced diameter of the at least one protruding structure (16, 16') (not shown in the figures). It is advantageous that the trimming process helps to reduce the width or the diameter of the at least one protruding structure in a simple and easily integrated way such that it allows for compliance with the scaling of feature sizes. It is also advantageous that the limitations with respect to the width or the diameter of the at least one protruding structure faced during the formation of the at least one protruding structure can be remedied allowing for reducing the width or the diameter of the at least one protruding structure.

In embodiments, the trimming process may comprise performing an oxidation process subsequent to forming the at least one protruding structure. It is advantageous that the trimming process comprising the oxidation process is performed in embodiments where the upper portion and the main portion of the at least one protruding structure is distinguishable **(****Fig. 4d****).** This allows for reducing the width or the diameter of the at least one protruding structure (16') without influencing its height. The oxidation process is also advantageous since it helps to cure the etch damage that the dry plasma etching may have caused. It is further an advantage of the oxidation process that it allows for obtaining smooth sidewalls of the at least one protruding structure (16').

In embodiments, the oxidation process may be a thermal oxidation process.

In embodiments, the oxidation may be a wet oxidation process.

In embodiments, the trimming process may further comprise removing the oxidized portions of the at least one protruding structure (16'). Removal of the oxidized portions may be done by performing an etch process. A hydrogen fluoride based chemistry, for instance diluted hydrogen fluoride, may be used if the oxidized portions contain silicon oxide or germanium oxide. A hydrogen chloride based chemistry may be used if the oxidized portions contain Group III/V compound semiconductor material.

In embodiments where the main portion of the at least one protruding structure comprises a Group III/V compound semiconductor material, the oxidation process may be subsequently followed by the removing of the oxidized portions. In these embodiments, the oxidation process may be performed by subjecting the structure (15) to an O₂ plasma or by subjecting to a H₂O₂ chemistry followed by subjecting the structure (15) to the hydrogen chloride based chemistry in order to remove the oxidized portions

In alternative embodiments, the trimming process may be carried out at the level of the photoresist layer. By performing an isotropic etch using an oxygen-comprising plasma, the width or the diameter of the at least one patterned photoresist feature (45) may be reduced.

In yet alternative embodiments, the patterning dielectric material (30) may be etched by using the at least one patterned photoresist feature (45), thereby forming at least one patterned dielectric material feature (not shown in the figures). Subsequently, the trimming process may comprise trimming the at least one patterned photoresist feature (45) together with the at least one patterned dielectric material.

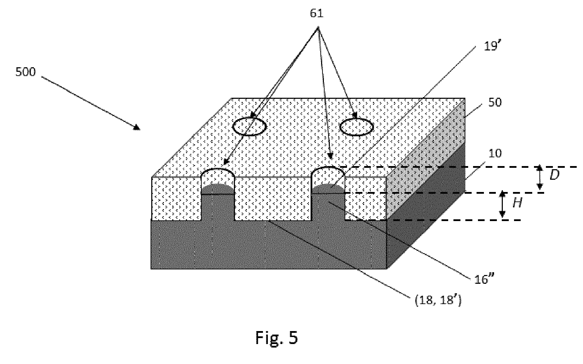

We now refer to **Figure 5****.**

**Figure 5** shows schematically a tilted view of the pre-patterned structure (500) shown in Fig. 3g and Fig 4g, respectively, that may be produced according to an embodiment of the present invention.

In embodiments, the pre-patterned structure (500) comprises a substrate (10) and at least one structure protruding and extending upwardly (16") from a main surface (18, 18') of the substrate (10). The at least one protruding structure (16") has a top surface (19') and a height H and comprise a monocrystalline semiconductor material. A dielectric material (50) overlays and is in contact with the main surface (18, 18'). The dielectric material (50) comprises at least one cavity (61) having a depth D. The at least one cavity (61) exposes, at its bottom, the top surface (19') of the at least one protruding structure (16") and is aligned with this at least one protruding structure (16").

In embodiments, the at least one cavity may be a hole. The hole may have a predetermined diameter. The predetermined diameter may be suitable for growth of vertical nanowires according to technology node in question. The hole (61) may be arranged in an array of holes, whereby each hole may be separated from each other vertically and/or horizontally by a predetermined distance.

The at least one cavity (61) exposes, at its bottom, a top surface (19') of the main portion (16") of the at least one protruding structure. The depth D may be smaller than a height H of the main portion (16") of the at least one protruding structure. The bottom of the at least one cavity (61) may not extend down to or lower than the level of the main surface (18, 18') of the substrate (10).

In embodiments, the depth D of the at least one cavity (61) may be at most 10 nm. In preferred embodiments, the depth D may be in the range of 5 nm to 10 nm.

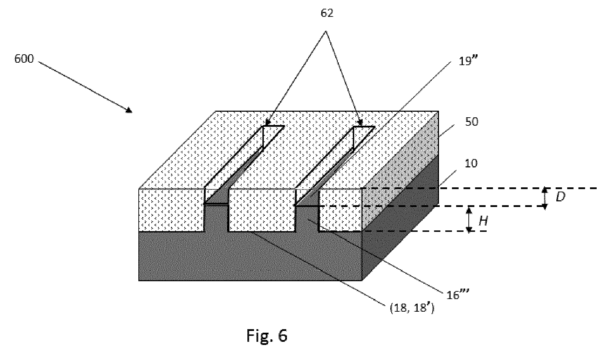

We now refer to **Figure 6****.**

In embodiments, the pre-patterned structure (600) comprises a substrate (10) and at least one structure protruding and extending upwardly (16"') from a main surface (18, 18') of the substrate (10). The at least one protruding structure (16"') has a top surface (19") and a height of h and may comprise a monocrystalline semiconductor material. A dielectric material (50) overlays and is in contact with the main surface (18, 18'). The dielectric material (50) comprises at least one cavity (62) having a depth D. The at least one cavity (62) exposes, at its bottom, the top surface (19") of the at least one protruding structure (16"') and is aligned with this at least one protruding structure (16"').

In embodiments, the at least one cavity may be a trench. The trench may have a predetermined width and length. The predetermined width and length may be suitable for growth of vertical nanosheets or fins structures according to technology node in question. The trench may be a single trench or may be arranged in an array of trenches. Each trench in the array maybe separated from each other by a predetermined distance.

The at least one cavity (62) exposes, at its bottom, a top surface (19") of the main portion (16"') of the at least one protruding structure. The depth D may be smaller than a height H of the main portion (16"') of the at least one protruding structure. The bottom of the at least one cavity (62) may not extend down to or lower than the level of the main surface (18, 18') of the substrate (10).

In embodiments, the depth D of the at least one cavity (62) may be at most 10 nm. In preferred embodiments, the depth D may be in the range of 5 nm to 10 nm.

## Claims

1. A method of producing a pre-patterned structure (500, 600) comprising at least one cavity (60) for growing a vertical nanostructure , the method comprising:
- providing at least one structure (16, 16') protruding and extending upwardly from a main surface (18, 18') of a substrate (10), wherein the at least one protruding structure (16, 16') has a main portion having a height H and an upper portion on the main portion and wherein at least the main portion comprises a monocrystalline semiconductor material,
- embedding the at least one protruding structure (16, 16') in a dielectric material (50),
- removing at least an excess portion (50') of the dielectric material (50) by performing a surface flattening process, thereby exposing a top surface of the upper portion and thereby forming a flattened surface (51) of the top surface and the dielectric material,
- thereafter, forming at least one cavity (60) having a depth of D by removing the upper portion, thereby exposing a top surface (19, 19' 19") of the main portion of the at least one protruding structure (16, 16').

2. The method according to claim 1, wherein, the depth D is smaller than the height H.

3. The method according to claim 1 or 2, wherein removing the upper portion of the at least one protruding structure (16, 16') is done by etching the upper portion selective to the dielectric material (50).

4. The method according to any of the preceding claims, wherein the at least main portion and the substrate (10) are made of the same monocrystalline semiconductor material.

5. The method according to any of the preceding claims, wherein the material of the upper portion is different than the material of the main portion.

6. The method according to claim 5, wherein the method further comprises performing an ion implantation process before embedding the at least one protruding structure (16, 16') in the dielectric material (50), thereby doping a lower part of the main portion and a region of the substrate underneath the at least one protruding structure with an n-type or a p-type dopant.

7. The method according to any of the preceding claims , wherein providing the at least one structure (16, 16') comprises,
- obtaining a substrate (10) covered with a patterning layer on a side thereof,
- forming at least one patterning layer feature (85) on that side of the substrate (10) and;
- etching anisotropically into the substrate, whereby the at least one patterning layer feature (85) is used as a mask, thereby forming the at least one structure (16, 16') protruding from the main surface (18, 18').

8. The method according to claim 7, wherein the patterning layer is a patterning layer stack (80) comprising an organic layer (20) overlying and in contact with the substrate (10) and a patterning dielectric material (30) overlying and in contact with the organic layer (20).

9. The method according to any of the preceding claims, wherein the monocrystalline semiconductor material is a (111) oriented Group IV semiconductor material or a (111)B oriented Group III/V compound semiconductor material.

10. A method for fabricating a vertical field effect transistor comprising:
- producing a pre-patterned structure (500, 600) according to any of claims 1 to 9,
- epitaxially growing, in the at least one cavity (60), a vertical nanostructure, wherein the vertical nanostructure comprises a channel region positioned in between a source region and a drain region,
- providing a gate stack to the vertical nanostructure suitable for controlling the channel region.

11. A pre-patterned structure (500, 600) comprising at least one cavity (60) for growing a vertical nanostructure, the pre-patterned structure comprising:
- a substrate (10) and at least one structure protruding and extending upwardly (16", 16"') from a main surface (18, 18') of the substrate (10) and having a top surface (19) and a height of H, wherein the at least one protruding structure comprises a monocrystalline semiconductor material, and;
- a dielectric material (50), overlying and in contact with the main surface, comprising at least one cavity (60) having a depth of D, wherein the at least one cavity (60) exposes, at its bottom, the top surface (19) of and, is aligned with, the at least one protruding structure.

12. The pre-patterned structure according to claim 11, wherein the depth D is smaller than the height H.

13. The pre-patterned structure according to claim 11 or 12, wherein the at least one protruding structure and the substrate comprise the same monocrystalline semiconductor material.

14. The pre-patterned structure according to claim 13, wherein a lower part of the main portion, and a region underneath the at least one protruding structure is doped with an n-type or a p-type dopant element.

15. A vertical field effect transistor comprising:
- the pre-patterned structure (500, 600) according to any of claims 11 to 14,
- a vertical nanostructure, in the at least one cavity, comprising a channel region positioned in between a source region and a drain region, and;
- a gate stack suitable for controlling the channel region, wherein the monocrystalline semiconductor material is a (111) oriented Group IV semiconductor material or a (111)B oriented Group III/V compound semiconductor material.
